(19) Europäisches Patentamt

**European Patent Office**

**Office européen des brevets**

(11) Veröffentlichungsnummer: **0 232 516**
A1

# (12) EUROPÄISCHE PATENTANMELDUNG

(21) Anmeldenummer: **86117237.7**

(22) Anmeldetag: **10.12.86**

(51) Int. Cl.⁴: **H 01 L 21/20,** H 01 L 21/76, H 01 L 21/82, H 01 L 21/203, H 01 L 27/06

(30) Priorität: **20.12.85 DE 3545241**

(43) Veröffentlichungstag der Anmeldung: **19.08.87 Patentblatt 87/34**

(84) Benannte Vertragsstaaten: **DE FR GB**

(71) Anmelder: **Licentia Patent-Verwaltungs-GmbH, Theodor-Stern-Kai 1, D-6000 Frankfurt/Main 70 (DE)**

(72) Erfinder: **Kasper, Erich, Dr. rer. nat., Osterholzweg 16, D-7914 Pfaffenhofen (DE)**
Erfinder: **Eichinger, Peter, Dr., Einsteinstrasse 80, D-8000 München 80 (DE)**

(74) Vertreter: **Schulze, Harald Rudolf, Dipl.-Ing. et al, Licentia Patent-Verwaltungs-GmbH Theodor-Stern-Kai 1, D-6000 Frankfurt/Main 70 (DE)**

(54) **Strukturierter Halbleiterkörper.**

㉗ Die Erfindung betrifft einen strukturierten Si-Halbleiterkörper, bei dem Halbleiter-Bauelemente, z.B. Transistoren und/oder Dioden, in mehreren Ebenen angeordnet sind. Dieses wird erreicht durch eine mehrmalige Anwendung der differentiellen SiMBE.

EP 0 232 516 A1

0232516

Licentia Patent-Verwaltungs-GmbH
Theodor-Stern-Kai 1
D-6000 Frankfurt 70


PTL-UL/Ja/rß
UL 85/160


Beschreibung


"Strukturierter Halbleiterkörper"

Die Erfindung betrifft einen strukturierten Halbleiterkörper nach dem Oberbegriff des Patentanspruchs 1.

Die Erfindung ist insbesondere anwendbar zur Herstellung
von Transistoren und/oder integrierten Schaltkreisen
(IC's) auf der Grundlage eines Silizium (Si)-Substrates.

In der am gleichen Anmeldetag eingereichten deutschen
Patentanmeldung mit dem internen Aktenzeichen UL 85/155
ist eine beispielhaft gewählte bipolare Halbleiterstruktur
beschrieben, die mit Hilfe von derzeit üblichen Verfahren,
z.B. Maskierungsverfahren durch Lithographie, Oxidations-,
Diffusions-, Implantations-, Epitaxie- sowie Metallisierungsverfahren herstellbar ist.

...

Bei einem derart strukturierten Halbleiterkörper ist insbesondere der Sperrbereich, z.B. ein als sperrender pn-Übergang dotierter Halbleiterbereich, lediglich durch kostenungünstige Isolationsdiffusions- und/oder Isolationsoxidationsvorgänge herstellbar. Dabei soll der Sperrbereich einen unerwünschten Stromfluß vermeiden, z.B. zwischen den benachbarten Transistoren eines IC's.

Der Erfindung liegt daher die Aufgabe zugrunde, einen gattungsgemäßen strukturierten Halbleiterkörper anzugeben, bei dem insbesondere der Sperrbereich zuverlässig und kostengünstig herstellbar ist und der bei einer zuverlässigen sowie kostengünstigen Herstellung eine möglichst hohe Packungsdichte von elektronischen Bauelementen ermöglicht.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Ein Vorteil der Erfindung besteht darin, daß insbesondere bei der Herstellung von dreidimensionalen Schaltkreisen die Maskierungs- sowie Kontaktierungsvorgänge in kostengünstiger Weise vereinfacht werden können.

Die Erfindung beruht auf der nachfolgend erläuterten Anwendung der sogenannten differentiellen Epitaxie auf Sihaltigem Material, die z.B. aus der Zeitschrift Journal of the Electrochemical Society 132, Seite 2227 (1985), bekannt ist. Dabei wird in einer Ultrahochvakuumanlage

...

(Vakuum kleiner $10^{-9}$mbar) mit Hilfe des Silizium-Molekularstrahlepitaxieverfahrens (Si-MBE) eine Si-Schicht aufgewachsen auf einem Si-Substrat, auf dem einkristalline Si-Bereiche sowie Siliziumdioxid ($SiO_2$)-Bereiche benachbart sind. Durch Wahl der Temperatur des Si-Substrates sowie des Vakuums, z.B. Art sowie Partialdruck von Restgasen, ist es gleichzeitig möglich, auf den einkristallinen Si-Bereichen einkristallines Si-Material aufzuwachsen während auf den $SiO_2$-Bereichen polykristallines Si-Material abgeschieden wird, dessen spezifische Leitfähigkeit einige Größenordnungen kleiner ist als diejenige des einkristallinen Si-Materials. Es entsteht ein genau bestimmbarer Übergang zwischen polykristallinem und einkristallinem Si-Material. Es ist möglich, die Wachstumsbedingungen so zu wählen, daß polykristallines und einkristallines Si-Material mit gleicher Schichtdicke abgeschieden werden. Dadurch entsteht an dem Übergang eine Stufe, deren Höhe lediglich von der Dicke der Siliziumdioxidschicht abhängt, die unter dem polykristallinen Silizium vorhanden ist.

Es ist sogar möglich, die $SiO_2$-Schicht dicker zu wählen als einen benachbarten einkristallienen Si-Halbleiterbereich und/oder einen benachbarten polykristallinen Si-Bereich. Ein lediglich auf $SiO_2$ selektiv wirkendes Ärzverfahren ermöglicht dann das selektive Wegätzen aller zugänglichen $SiO_2$-Bereiche, so daß darunter liegende einkristalline und/oder polykristalline Si-Bereiche zugänglich sind, z.B. für eine Kontaktierung durch einen Metallisierungsvorgang.

...

Diese Eigenschaften sind nutzbar zur Herstellung der folgenden beispielhaft gewählten Halbleiterstrukturen, die anhand einer schematischen Zeichnung näher erläutert wird. Es zeigen

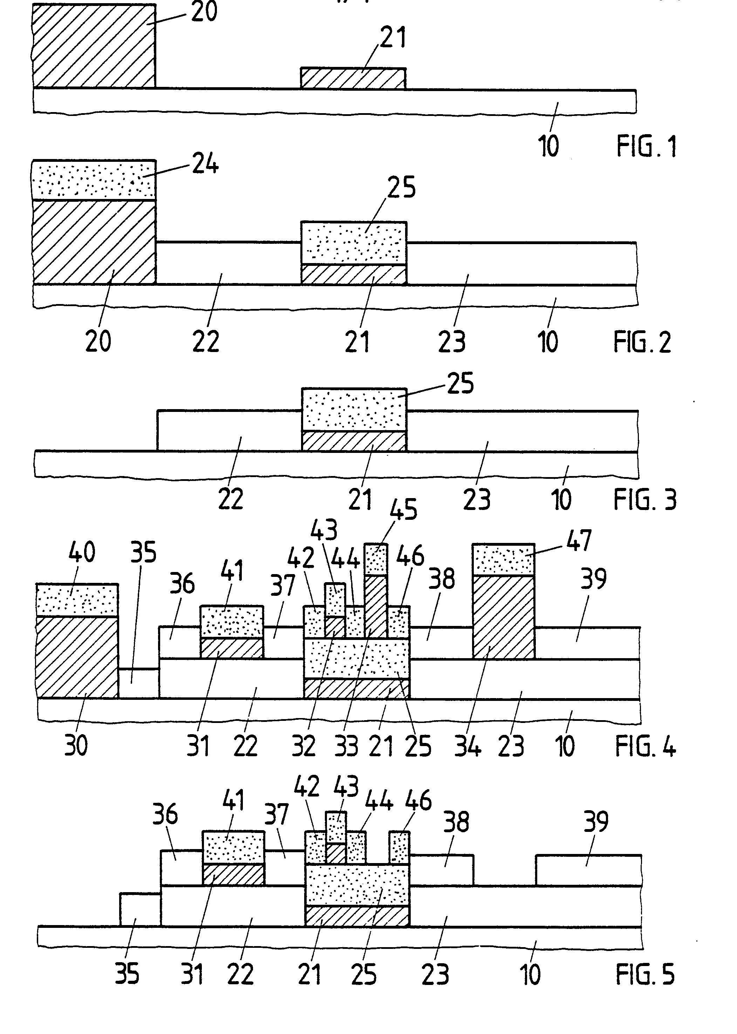

Fig. 1 bis 5    Querschnitte durch Ausführungsbeispiele zur Erläuterung der Erfindung.

Fig. 1 zeigt ein in der Halbleitertechnologie derzeit üblicher $p^-$-dotiertes Si-Substrat 10, in dem beispielsweise eine nicht dargestellte $n^+$dotierte vergrabene Halbleiterzone vorhanden ist sowie durch Dotierungsverfahren, hergestellte, nicht dargestellte, Halbleiterbauelemente, z.B. Transistoren und/oder Dioden. Es ist eine erste Halbleiter-Bauelementebene entstanden. Auf dieser ersten Halbleiter-Bauelementebene werden nun mit Hilfe derzeit überlicher Verfahren beispielsweise unterschiedliche dicke $SiO_2$-Bereiche 20, 21 erzeugt, zwischen denen einkristallines Si-Substratmaterial zugänglich ist.

Bei einer nachfolgend durchgeführten diffentiellen Si-MBE entstehen auf dem einkristallinen Si-Substratmaterial einkristalline Halbleiterbereiche 22, 23, deren Schichtdicke größer ist als diejenige des dünnen $SiO_2$-Bereiches 21 jedoch kleiner als diejenige des dicken $SiO_2$-Bereiches 20. Auf den $SiO_2$-Bereichen 20, 21 entstehen polykristalline Si-Bereiche 24, 25, deren Schichtdicke im wesentlichen gleich derjenigen der Si-Bereiche 24, 25 ist. Durch nachfolgende Diffusions- und/oder Implantationsverfahren ist es möglich, in den Si-Bereichen 24, 25 weitere Halbleiterbauelemente zu erzeugen. Es ist eine zweite Halbleiter-Bauelementebene entstanden.

. . .

Gemäß Fig. 3 ermöglich nun ein selektiv auf $SiO_2$ wirkendes Ätzverfahren, z.B. eine HF-Ätze , daß lediglich das zugängliche $SiO_2$ weggeätzt wird. Dieses ist lediglich bei dem dicken $SiO_2$-Bereich 20 der Fall, da dieser $SiO_2$-Bereich 20 seitlich durch das Ätzmedium angreifbar ist. Der darauf befindliche polykristalline Si-Bereich 24 wird dadurch unterätzt und dadurch ebenfalls entfernt. Das unter dem dicken $SiO_2$-Bereich 20 gelegene Si-Substratmaterial ist nun zugänglich, z.B. zur Herstellung von elektrischen Leiterbahnen (Verbindungsleitungen) für Kontaktierungszwecke.

Gemäß Fig. 4 wird eine dritte Halbleiter-Bauelementebene dadurch hergestellt, daß zunächst wieder unterschiedlich dicke $SiO_2$-Bereiche 30 bis 34 auf einkristallinem Silizium 22, 23 und/oder polykristallinem Silizium 25 erzeugt werden. Durch eine nachfolgend angewandte Si-MBE entstehen wieder, wie anhand Fig. 2 beschrieben, weitere einkristalline Si-Bereiche 35 bis 39 sowie weitere polykristalline Si-Bereiche 40 bis 47. Dabei sind die Schichtdicken entsprechend den in Fig. 2 beschriebenen Verhältnissen gewählt. Durch bereits erwähnte Dotierungsverfahren ist es möglich, in den einkristallinen Si-Bereichen 35 bis 39 die Halbleiter-Bauelemente der dritten Bauelementeebene zu erzeugen. Durch das anhand der Fig. 3 beschriebene selektive $SiO_2$-Ätzverfahren werden nun beispielsweise die dicken $SiO_2$-Bereiche 30, 33, 34 entfernt, so daß darunterliegende einkristalline und/oder polykristalline Bereiche zugänglich sind, z.B. zur Herstellung von weiteren Leiterbahnen. (Fig. 5).

...

Es ist nun möglich, den beschriebenen Schichtaufbau nahezu beliebig fortzusetzen, so daß z.B. ein integrierter Schaltkreis (IC) mit einer Vielzahl von Halbleiter-Bauelementebenen entsteht. In dem IC ist daher eine sehr hohe Packungsdichte von Halbleiter-Bauelementen vorhanden. Außerdem sind kurze Verbindungsleitungen zwischen den Halbleiter-Bauelemente und/oder den Halbleiter-Bauelementeebenen möglich, so daß vorteilhafterweise hohe Grenzfrequenzen und/oder sehr kurze Schaltzeiten des IC's ermöglicht werden.

Da das polykristalline Silizium eine spezifische elektrische Leitfähigkeit hat, die um einige Größenordnungen kleiner ist als diejenige der einkristallinen Si-Halbleiterbereiche, ist es überraschenderweise möglich, in kostengünstiger Weise passive elektrische Widerstände zu integrieren. Dazu wird beispielsweise während einer $n^+$-Dotierung eines Emitters in dem polykristallinen Silizium 25, das unterhalb des $SiO_2$-Bereiches 33 liegt, ein Widerstandbereich so stark dotiert, daß dort eine nutzbare Leitfähigkeit von z.B. $10^2 (Ohm \ cm)^{-1}$ entsteht. Über die geometrischen Ausmaße (Länge, Breite, Dicke) ist dann ein gewünschter Widerstandswert von z.B. 10 kOhm einstellbar. Der Widerstandsbereich ist dann z.B. nach dem Entfernen des $SiO_2$-Bereiches 33 kontaktierbar durch metallische Leiterbahnen. Auf diese Weise ist in kostengünstiger Weise beispielsweise eine Kombination aus mehreren Transistoren und einem passiven Widerstandsnetzwerk als integriertes Bauelement herstellbar.

0232516

Licentia Patent-Verwaltungs-GmbH
Theodor-Stern-Kai 1
D-6000 Frankfurt 70

PTL-UL/Ja/rß
UL 85/160

Patentansprüche

1. Strukturierter Halbleiterkörper, zumindest bestehend aus unterschiedlich dotierten Siliziumeinkristall-Halbleiterbereichen, die durch mindestens einen Sperrbereich begrenzt sind, dadurch gekennzeichnet,
- daß der Sperrbereich (21, 25) zumindest teilweise aus polykristallinem Silizium (25) besteht und
- daß unter Anwendung der differentiellen Molekularstrahl-Epitaxie auf einem Silizium-Substrat (10) mindestens zwei übereinanderliegende Halbleiterebenen (23, 39) aufgewachsen sind, die jeweils mindestens ein Halbleiterbauelement enthalten.

2. Strukturierter Halbleiterkörper nach Anspruch 1, dadurch gekennzeichnet, daß zu mindestens einer Halbleiterebene mindestens zwei unterschiedlich dicke Oxidschich-

...

ten (20, 21) gehören, wobei die dickere Oxidschicht (20) wesentlich dicker ist als der zu der Halbleiterebene gehörende Halbleiterbereich (22, 23).

3. Strukturierter Halbleiterkörper nach Anspruch 1 oder Anspruch 2, dadurch gekennzeichnet, daß in dem polykristallinem Silizium (25) von mindestens einem Sperrbereich (21, 25) mindestens ein Widerstandsbereich vorhanden ist.

FIG. 1

FIG. 2

FIG. 3

FIG. 4

FIG. 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A,D | JOURNAL OF THE ELECTROCHEMICAL SOCIETY, Band 132, Nr. 9, September 1985, Seiten 2227-2231, Manchester, New Hampshire, US; H.-J. HERZOG et al.: "Silicon layers grown by differential molecular beam epitaxy" * Seite 2227, Spalte 1, Absatz 1 - Spalte 2, Absatz 3; Seite 2231, Spalte 1, Absatz 3 - Spalte 2, Absatz 4 * | 1,3 | H 01 L 21/20<br>H 01 L 21/76<br>H 01 L 21/82<br>H 01 L 21/28<br>H 01 L 27/06 |
| A | DE-B-1 639 581 (TELEFUNKEN) * Patentansprüche 1,9,10 * | 1 | |
| A | GB-A-4 179 312 (IBM) * Spalte 6, Zeile 16 - Spalte 7, Zeile 65; Patentansprüche 10-15 * | 1 | |
| | | | RECHERCHIERTE SACHGEBIETE (Int. Cl.4)<br><br>H 01 L |

Der vorliegende Recherchenbericht wurde für alle Patentansprüche erstellt.

| Recherchenort<br>DEN HAAG | Abschlußdatum der Recherche<br>27-04-1987 | Prüfer<br>VANCRAEYNEST F.H. |
|---|---|---|